# EUROPEAN PATENT APPLICATION

(11) **EP 1 198 012 A2**
(43) Date of publication of application: **17.04.2002**
(21) Application number: 01123702.1
(22) Date of filing: 03.10.2001
(51) Int. Cl.: H01L 31/048, E04D 13/18

(54) **Surface cladding element comprising a photovoltaic cell**

(30) Priority: 03.10.2000 IT MO000208
(71) Applicant: Veicoli S.r.l., 41100 Modena (IT)
(72) Inventor: Sala, Filippo, 41043 Formigine (Modena) (IT); Scorcioni, Allessandro, 41100 Modena (IT)
(74) Representative: Crugnola, Pietro

(57) **Abstract**

A surface-cladding element comprises a support body (2) that can be fixed to a product and a visible surface (4) arranged to face an environment in which said cladding element (1) is located, said cladding element further comprising at least a photovoltaic cell (6) that is associated to said support body (2) so as to constitute at least part of said visible surface (4).

## Description

The invention concerns a cladding product for surfaces, of architectural structures in particular, in other words a preferably flat product that comprises a support - such as a ceramic tile - to be fitted to a base body to clad it.

In the prior art, different finishes for buildings are known, for example, slabs of natural or artificial stone, or flat ceramic tiles of widely varying dimensions and geometrical shapes.

The function of these finishing elements is to protect the structure to which they are fitted from inclement weather and wear and to embellish it.

Nevertheless, the different types of cladding elements that are available constitute a limited range of products the characteristics of which are basically equivalent to one another.

Certain compositions of ceramic tiles are fairly small in dimension and are often indicated by the term 'mosaic', they comprise a range of ceramic tile elements with preset shapes and colours, which elements are fixed to a backing sheet in order to create a preset pattern. Between each ceramic tile element and between the elements that surround them there are gaps that constitute the so-called 'grouting' that receive a fixing material designed to connect the different elements to one another.

At the moment of installation, all the elements connected to the same backing sheet are positioned simultaneously and the backing sheet is immersed in the cement, which fixes the elements to a floor or a wall.

An object of the invention is to extend the technical functions available to surface-cladding elements.

In particular, it would be desirable to endow surface-cladding elements with electrical properties moreover to their normal mechanical functions.

According to a first aspect of the present invention, there is provided a surface-cladding element comprising a support body that can be fixed to a product and a visible surface arranged to face the environment wherein said cladding element is located, characterised therein that it comprises at least one of said photovoltaic cells that is fitted to said support body in such a way as to constitute at least one part of said visible surface.

It is preferable to insert the photovoltaic cell into a chamber of said support body.

It is also preferable that the support body should comprise a ceramic tile.

In one advantageous embodiment, the tile also comprises at least two holes that are arranged so as to enable the conductors to pass through to electrically connect the photovoltaic cell to further adjacent cells, or to devices that accumulate and/or use electric power.

The invention enables surface-cladding elements to be endowed with electricity-generating properties that did not exist in the prior art, which can be particularly useful when the surfaces to be clad are near a device that uses electric power: in such cases cables do not need to be laid and connection to the power distribution network is not required.

Moreover, this favours the spread of photovoltaic cells inasmuch as the combination of the photovoltaic cells and the support body can create aesthetically pleasing effects.

In the prior art photovoltaic cells have generally been used only in the context of photovoltaic panels to generate electric power. The photovoltaic panels comprise a support element that lets through light irradiation to which several photovoltaic cells are fixed, generally by means of polymers acting as cements, the photovoltaic cells are connected together electrically so that at the heads of the connecting electric circuit a difference in potential power can be collected that can be used for different applications.

Owing to their purely technical purpose, prior-art photovoltaic panels are aesthetically unappealing and may thus significantly detract from the appearance of a building to which they are applied. This is even more noticeable in cases in which said buildings are located in places such as areas by the sea or in the mountains that are extremely favourable due to their high exposure to the sun's rays but wherein the beauty of the natural surroundings is significantly lessened by the presence of aesthetically displeasing panels fitted to buildings.

In such circumstances the use of photovoltaic cells has therefore been prevented.

The general appearance of a composition of photovoltaic cells has accordingly been significantly improved.

Moreover, it is possible to create compositions of photovoltaic cells and panels that can be applied to products to create pleasing aesthetic effects and generate a given quantity of electric power.

In another advantageous embodiment, one photovoltaic cell is fitted to each support body.

In a further advantageous embodiment, several photovoltaic cells are fitted to a support body of relatively large dimensions.

In yet another advantageous embodiment, the metal items that are arranged to collect the electrons from the top face of the photovoltaic cells can be arranged into set patterns to help further heighten the aesthetic appeal of the tiles.

According to a second aspect of the invention there is provided a decorative unit comprising several surface-cladding elements that are fixed to means of support that supply structural resistance to said units to facilitate installation, characterised therein that said surface-cladding elements comprise photovoltaic cells the top faces of which are visible on the visible surface of said surface-cladding elements and therein that said means of support comprise means of electrical interconnection of said photovoltaic cells.

The invention enables decorative units to be obtained that comprise tiles fitted with photovoltaic cells that can easily be positioned on products without having to electrically connect the cells of the single tiles to one another.

As the photovoltaic cells that are to be fitted to the tiles can be made in different colours, when the silicon wavers of which they are constituted are made, decorative units can be created with pleasing aesthetic effects that are easy to install and which also enable a given quantity of electric power to be generated.

Moreover, it is possible to create photovoltaic panels with support and connection elements between the photovoltaic cells that enable said panels to be fitted to building products and facilitate their installation.

The invention enables surface-cladding elements to be created that combine with the decorative effects that are typical of ceramic materials the capacity to generate electric power.

In particular, said tile or said decorative unit can be used to create decorations within or outside buildings, for example for pools, fountains, garden paths whilst enabling the power to be generated that is required to actuate the pumps of said fountain or supply the lamps that illuminate said gardens.

In order that the invention may be clearly and completely disclosed, reference will now be made, by way of examples that do not limit the scope of the invention, to the accompanying drawings, wherein:
Figure 1 is a front view of a tile, according to the invention, to which a photovoltaic cell has been fitted;
Figure 2 is a section taken along a plane II-II of Figure 1 that shows the holes made for the passage of the connecting wires in the bottom face of the tile;
Figure 3 is a fragmentary front view of several tiles that shows the means of support comprising the means of electrical interconnection of the photovoltaic cells;
Figure 4 is a partially interrupted section taken along a plane IV-IV of the figure;
Figure 5 is a section like Figure 2 that shows the holes for the passage of the connecting wires, which holes are made in the sides of the tile;
Figure 6 is a front diagrammatic view of a plurality of photovoltaic cells, associated to the respective tiles, that shows the means of support and the means of electrical interconnection;
Figure 7 is a front view of a tile wherein the metal items of the photovoltaic cell fitted to it have been arranged according to set patterns;
Figure 8 is a front view of a large tile containing several photovoltaic cells.

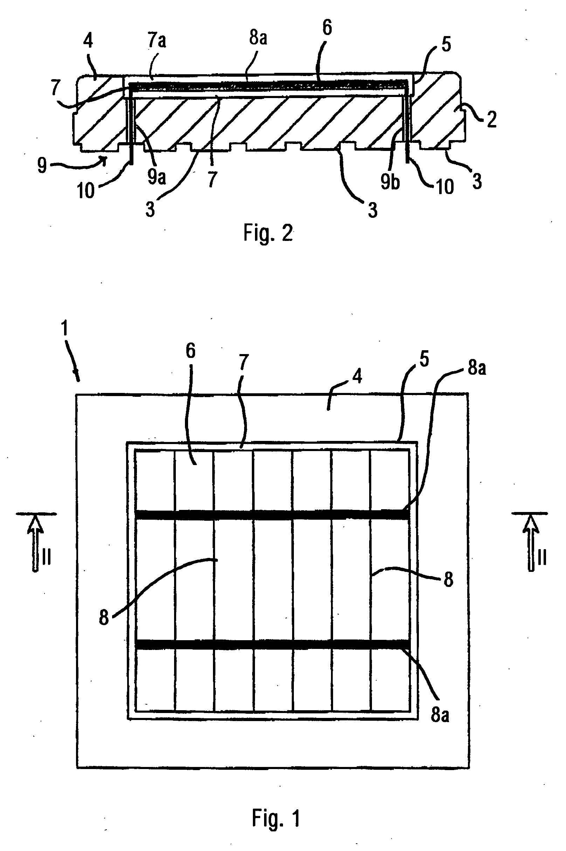

Figures 1 and 2 show a ceramic tile 1 comprising a support body 2, the bottom surface of which is provided with several supports 3, arranged to enable it to be fixed to a masonry structure, and a visible face 4. In the support body 2, on the side of the visible face 4, a device such as a device for water cutting of tiles is used to create a chamber 5 for housing a photovoltaic cell 6 or said chamber 5 is created in said support body 2 directly during the pressing phase.

The photovoltaic cell 6 can be obtained from thin silicon wavers whose diameter varies between a few tenths and a few hundredths of a millimetre, said silicon can be of three different types: moncrystalline, polycrystalline, or amorphous (although not preferable), which differ in terms of the performance of the finished products and their relative costs.

On the silicon wavers metal is deposited in the form of several conductor lines that are arranged in such a way as to extend to virtually all parts of the silicon waver and which are arranged to collect the electrons that are made available following the irradiation of the silicon by photons.

In the prior-art photovoltaic panels described above the top faces provided with metal deposits are placed in contact with the glass support element whilst the bottom faces are covered with a film of plastic material the sole purpose of which is to protect the panel.

In another embodiment, the photovoltaic panels are created by using a metal table, for example an aluminium table, as a support element, on which the bottom faces of the photovoltaic cells are fixed, normally through gluing, which, once the relative interconnection connections have been created, will create the aforementioned panel. In this case, the top faces of the cells are protected by a layer of plastic material such as polymer resin that is deposited on them.

The photovoltaic cell 6 is fitted to the inside of the chamber 5 by means of a polymer resin 7 such as an epoxy resin that is located below and to the side of the cell 6. A further layer of resin 7a is deposited on the top face of the cell 6 to constitute an element providing protection against atmospheric agents.

The top face of the photovoltaic cell 6 comprises first metal conductor filaments 8 and second metal conductor filaments 8a that collect the electrons generated by light irradiation.

The first metal conductor filaments 8 are designed to be as thin as possible, in order not to reduce the surface affected by the photovoltaic effect, and are arranged all over the surface of the cell 6 to increase the probability of capturing free electrons whereas the second conductor filaments 8a are larger in dimension and not only capture electrons but also act as collector means for the electrons intercepted by the first metal conductor filaments 8.

The support body 2 has two pairs of through holes 9 that are arranged to enable the connecting wires 10 to pass through, which are normally in silver-plated copper, and arranged to connect the cell 6 to further cells 6 or to devices that use or accumulate electric power.

The two pairs of through holes 9 comprise a first pair 9a that is arranged to house wires with given polarity, for example positive, and a second pair 9b, that is arranged to house the wires with the opposite type of polarity, in this case negative.

The electrical connection is also ensured by a single pair of wires, one for each type of polarity, the use of the two wires for each type of polarity ensures that the cell 6 will function even in the event of an accidental interruption to the connection, for example due to the breakage of one of the said wires.

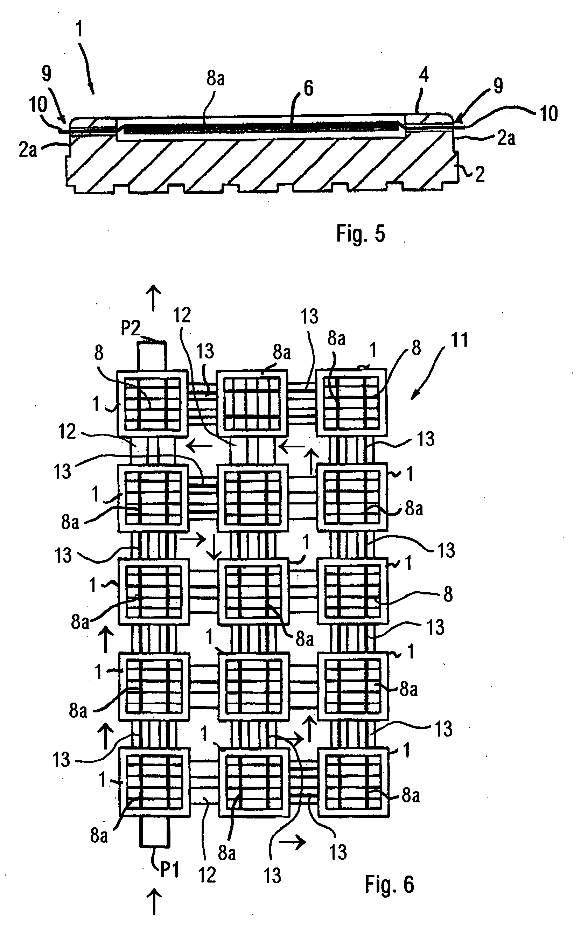

Figure 5 shows a tile 1 wherein the holes 9 are made in the side surfaces 2a of the support body of the tile 1. This enables the cell 6 of the tile 1 to be directly connected to further cells positioned near it by simply connecting the wires 10 to the wires that emerge from the body of the adjacent tiles using means such as a soldering unit.

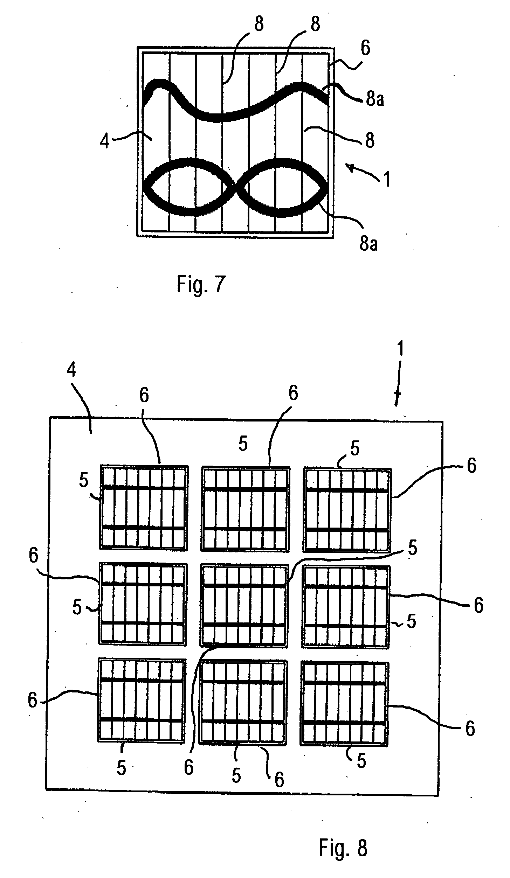

Figure 8 shows a large tile 1 containing several photovoltaic cells 6, each one of which is housed in a chamber 5.

Figure 7 shows a photovoltaic cell 6 that comprises on its top face 4 the first metal conductor filaments 8 and the second metal conductor filaments 8a that are arranged in such a way as to form a decorative motif. This decorative motif can be created on the single cell 6 or can be created by combining several cells 6, each one of which displays on its surface part of the design that is to be obtained.

Obviously, the decorative motifs can be extremely varied and, for example, include geometrical and/or figurative decorations.

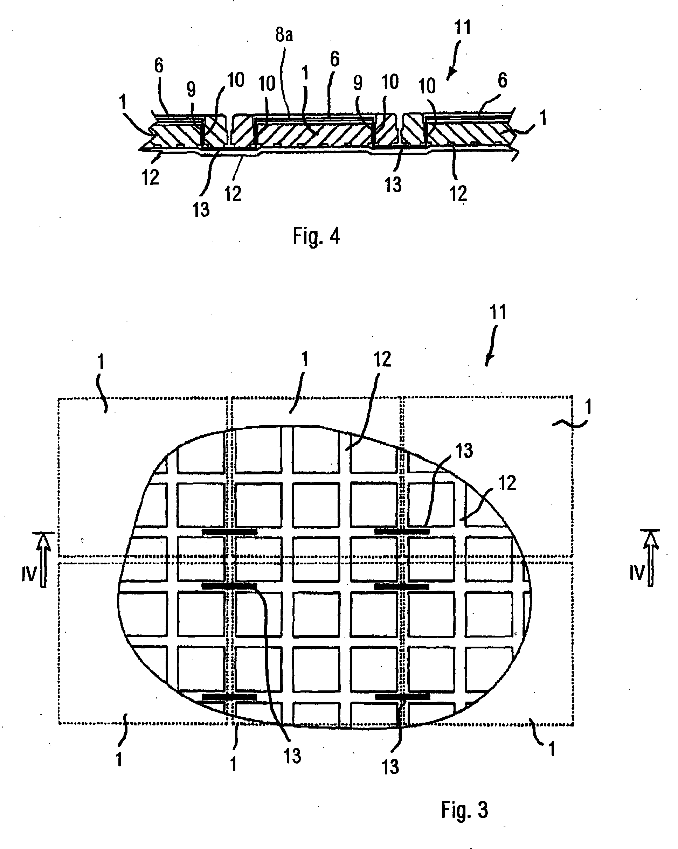

Figures 3 and 4 show a decorative unit 11 that comprises several ceramic tiles 1 fixed to means of support 12 that provide structural resistance to said decorative unit 11 to facilitate installation operations.

The means of support 12 can be formed into a net with, for example, square meshes to which the tiles 1 are fixed by gluing the relative supports 3.

The means of support 12 are deformable to a certain extent, which favours transport operations and installation of the decorative unit 11 whilst at the same time ensuring that the tiles 1 maintain their relative positions.

The means of support 12 comprise the means of electrical interconnection 13 of the cells 6, which may consist of bands of conductor material such as silver-plated copper.

The means of support 12 extend over the entire decorative unit 11 as they are provided with the said means of electrical interconnection 13 only in the preset areas so as to connect the cells 6 according to a well defined wiring diagram.

As shown in Figure 4, the means of electrical interconnection 13 can connect to one another the wires 10 of two consecutive cells 6.

Figure 6, moreover, shows the diagram of a decorative unit 11 comprising several tiles, the photovoltaic cells 6 of which are serially collected.

Figure 6 also shows the connection in detail, in fact starting from clamp P1 and following the route of the means of electrical interconnection 13, as indicated by the arrows, all the cells 6 can be serially connected as far as clamp P2.

Clamps P1 and P2 are connected at end positions in order to enable easy connection to the relative clamps of any additional decorative units adjacent to unit 11.

## Claims

1. Surface-cladding element comprising a support body (2) that can be fixed to a visible surface (4) arranged to face an environment wherein said cladding element (1) is located, **characterised in that** it comprises at least one photovoltaic cell (6) associated to said support body (2) in such a way as to constitute at least part of said visible surface (4).

2. Cladding element according to claim 1, wherein said support body (2) comprises chamber means (5) that is arranged to accommodate said at least one photovoltaic cell (6).

3. Cladding element according to claim 1, or 2, and further comprising fixing means (7) that is arranged for fixing said at least one photovoltaic cell (6) to said support body (2).

4. Cladding element according to claim 3, wherein said fixing means (7) comprises polymer resins.

5. Cladding element according to one of the preceding claims, wherein above said at least one photovoltaic cells (6) protective means (7a) is arranged that is transparent to light irradiation and is arranged to protect said at least one photovoltaic cell (6) from external agents.

6. Cladding element according to claim 5, wherein said protective means (7a) comprises polymer resins.

7. Cladding element according to one of the preceding claims, wherein said at least one photovoltaic cell (6) comprises metal conductor means (8, 8a) for collecting electrons generated by light irradiation of said at least one photovoltaic cell (6).

8. Cladding element according to claim 7, wherein said metal conductor means (8, 8a) is arranged to form a decorative motif on said at least one photovoltaic cell (6).

9. Cladding element according to one of the preceding claims, wherein at least one pair of holes (9) is obtained in said support body (2) in such a way as to enable connecting wire means (10) to pass through to connect said at least one cell (6) to other adjacent cells (6) or to devices using and/or accumulating electric power.

10. Cladding element according to claim 9, wherein said pair of holes comprises a first hole (9a) arranged to house said connecting wire means (10), said connecting wire means have a given type of polarity, and a second hole (9b) arranged to house said connecting wire means (10), said connecting wire means have the opposite type of polarity.

11. Cladding element according to claim 9, or, 10 wherein at least one of said pair of holes comprises two pairs of holes (9) arranged to ensure operation of said at least one photovoltaic cell (6) in the event of breakage of one of said connecting wire means (10).

12. Cladding element according to one of claims 9 to 11, wherein at least one of said pairs of holes (9) affects a surface of said cladding element (1) that is opposite said visible surface (4).

13. Cladding element according to one of claims 9 to 11, wherein at least one of said pairs of holes (9) affects side surfaces (2a) of said support body (2).

14. Cladding element according to one of the preceding claims, wherein said support body (2) comprises a ceramic tile.

15. Decorative unit comprising a plurality of surface-cladding elements (1) fixed to support means (12) that supply structural resistance to said unit (11) to facilitate its installation, **characterised in that** said surface-cladding elements (1) comprise photovoltaic cells (6), the top surfaces of which are visible on the visible surface (4) of said surface-cladding elements (1) and **in that** said support means (12) comprises electrical interconnection means (13) interconnecting said photovoltaic cells (6).

16. Decorative unit according to claim 15, wherein said support means (12) comprises net means to which means of support (3) for said cladding means is fixed.

17. Decorative unit according to claim 15, or 16, wherein said support means (12) is made of partially deformable material to facilitate the transport and positioning of said decorative unit (11).

18. Decorative unit according to one of claims 15 to 17, wherein said electrical interconnection means (13) comprises bands of conductor material.

19. Decorative unit according to claim 18, wherein said conductor material comprises silver-plated copper.

20. Decorative unit according to one of claims 15 to 19, wherein said photovoltaic cells (6) are associated to support bodies of said cladding elements (1).

21. Decorative unit according to claim 20, wherein said support bodies (2) comprise chamber means (5) arranged to house said photovoltaic cells (6).

22. Decorative unit according to one of claims 15 to 21, and further comprising fixing means (7) for fixing said photovoltaic cells (6) to said support bodies (2).

23. Decorative unit according to claim 22, wherein said fixing means (7) comprises polymer resins.

24. Decorative unit according to one of claims 15 to 23 wherein on top of said photovoltaic cells (6) transparent protective means (7a) is arranged that is transparent to light irradiation and arranged to protect said photovoltaic cells (6) from external agents.

25. Decorative unit according to claim 24, wherein said protective means (7a) comprises polymer resins.

26. Decorative unit according to one of claims 15 to 25, wherein said photovoltaic cells (6) comprise metal conductor means (8, 8a) that collect electrons generated by light irradiation of said photovoltaic cells (6).

27. Decorative unit according to claim 26, wherein said metal conductor means (8, 8a) is arranged in such a way as to form a decorative motif on said photovoltaic cells (6).

28. Decorative unit according to one of claims 15 to 27, wherein in said support bodies (2) at least one pair of holes (9) is obtained to enable connecting wire means (10) to pass through in order to connect said cells (6) to said electrical interconnection means (13).

29. Decorative unit according to claim 28, wherein said pair of holes comprises a first hole (9a) arranged to house said connecting wire means (10) that have a given type of polarity, and a second hole (9b) arranged to house connecting wire means (10) that have the opposite type of polarity.

30. Decorative unit according to claim 28 or 29, wherein at least one of said pairs of holes comprises two pairs of holes (9) arranged to ensure operation of said cells (6) in the event of breakage of one of said connecting wire means (10).

31. Decorative unit according to one of claims 28 to 30, wherein at least one of said pair of holes (9) affects a rear surface of said cladding elements (1).

32. Decorative unit according to one of claims 28 to 30, wherein at least one of said pair of holes (9) affects side surfaces (2a) of said support bodies (2).

33. Cladding element according to one of claims 16 to 33, wherein said cladding elements (1) comprise ceramic tiles.
